# EUROPÄISCHE PATENTSCHRIFT

(11) **EP 2 321 882 B1**
(45) Veröffentlichungstag und Bekanntmachung des Hinweises auf die Patenterteilung: **04.07.2012**
(21) Anmeldenummer: 09748968.6
(22) Anmeldetag: 01.10.2009
(51) Int. Cl.: H01R 25/00, H05K 7/14

(54) **Serverschrank**
Server cabinet
Armoire de serveur

(30) Priorität: 07.10.2008 DE 102008050700
(43) Veröffentlichungstag der Anmeldung: 18.05.2011
(73) Patentinhaber: Knürr GmbH, 94424 Arnstorf (DE)
(72) Erfinder: FEIGL, Josef, 94424 Arnstorf (DE)
(74) Vertreter: Heim, Hans-Karl
(86) Internationale Anmeldenummer: PCT/EP2009/007056
(87) Internationale Veröffentlichungsnummer: WO 2010/040475

(56) Entgegenhaltungen:
- US-A1- 2002 012 242
- US-A1- 2005 000 786
- US-A1- 2005 094 357
- US-A1- 2007 072 487
- US-A1- 2008 029 428
- US-B1- 6 229 691

## Beschreibung

Die Erfindung betrifft einen Serverschrank zur Aufnahme von elektrischen und/oder elektronischen Geräten mit einer Verteilerleiste zur Verteilung von elektrischer Energie an die in dem Serverschrank angeordneten Geräte, wobei die Verteilerleiste auzweist mehrere elektrische Anschlusseinrichtungen, an welche elektrische Verbraucher anschließbar sind, mindestens eine Zuleitungskabel zum Verbinden der Verteilerleiste mit einer Energiequelle und mindestens einen Befestigungsbereich zum Befestigen der Verteilerleiste an dem Serverschrank.

Verteilerleisten dienen zum Verteilen von elektrischer Energie an elektrische und/oder elektronische Geräte oder Baueinheiten, welche in einem Geräte- und/oder Serverschrank angeordnet sind. Allgemeiner ausgedrückt versorgt eine Verteilerleiste elektrische Verbraucher mit Energie. Derartige versorgte Geräte oder Baueinheiten sind beispielsweise Server, wie Blade-Server, Telekommunikationsgeräte, Klimageräte, Switches oder Klimageräte.

Die Verteilerleiste, welche auch als Dosenleiste bezeichnet werden kann, ist bei bekannten Geräteschränken meist vertikal angeordnet.

Zum Verbinden der Verteilerleiste mit einer Energiequelle, beispielsweise einem Stromnetz, ist aus der Verteilerleiste ein Zuleitungskabel herausgeführt. Dieses wird in geeigneter Weise durch den Geräteschrank verlegt und zum Anschließen an einen Stromanschluss, wie eine Netzsteckdose, aus dem Schrank herausgeführt. Ebenso kann das Zuleitungskabel mit der Gebäude- oder Rechenzentrumsenergieversorgung verbunden werden.

Neben solchen im Wesentlichen eigenständigen Verteilerleisten ist es auch bekannt, Elektrifiziereinrichtungen integral mit dem Geräteschrank auszubilden.

Die in Geräte- oder Serverschränken untergebrachten Geräte und Verbraucher werden immer leistungsstärker. Hierdurch erhöht sich auch ihr Energieverbrauch. Zusätzlich besteht eine Tendenz, eine immer größere Anzahl an Geräten in einem Geräte- oder Serverschrank unterzubringen. Beide Entwicklungen führen zu einem insgesamt steigenden Energiebedarf in einem Geräte- oder Serverschrank und erfordern somit immer leistungsfähigere Verteilersysteme zur Verteilung elektrischer Energie an die zu versorgenden Geräte und Verbraucher.

Um die hohen Stromstärken beziehungsweise -leistungen für die Verbraucher bereitzustellen, ist es notwendig, die Zuleitungskabel zu den Verteilerleisten entsprechend zu dimensionieren. Deswegen ist man bestrebt, die Durchmesser der Zuleitungskabel zu vergrößern. Dies vermindert zusätzliche Leitungsverluste in diesen Kabeln.

Aufgrund des begrenzten Raumangebots innerhalb eines Geräteschrankes können solche Zuleitungskabel mit großen Durchmessern Probleme darstellen. Insbesondere bereiten die vergleichsweise großen Biegeradien, welche sich aufgrund der großen Durchmesser der Kabel ergeben, bei der Verlegung häufig Schwierigkeiten, da die möglichen Biegeradien für die Zuleitungen bei der Verwendung von gattungsgemäßen Verteileinrichtungen meist nur sehr klein sind.

Der Erfindung liegt die **Aufgabe** zugrunde, einen Serverschrank mit einer leistungsstarken Energieversorgung zu schaffen.

Die Aufgabe wird erfindungsgemäß durch eine Serverschrank mit den Merkmalen des Anspruchs 1 gelöst. Bevorzugte Ausführungsformen der Erfindung sind in den jeweiligen abhängigen Ansprüchen angegeben.

Es ist erfindungsgemäß vorgesehen, dass die elektrischen Anschlusseinrichtungen an einer ersten Längsseite der Verteilerleiste angeordnet sind, dass das mindestens eine Zuleitungskabel an einer der ersten Längsseite benachbarten zweiten Längsseite der Verteilerleiste angeordnet ist und dass die Verteilerleiste mittels des Befestigungsbereichs in einer vertikalen Ausrichtung im Bereich einer Seitenwand an dem Serverschrank befestigbar ist.

Ein Grundgedanke der Erfindung kann darin gesehen werden, einen Serverschrank mit einer Verteilerleiste zu schaffen, dessen Zuleitungskabel selbst bei großem Durchmesser und damit einhergehendem großem Biegeradius unkompliziert innerhalb eines Serverschrankes verlegt werden kann.

Ein wesentlicher Aspekt der Erfindung besteht darin, das Zuleitungskabel der Verteilerleiste nicht, wie im Stand der Technik bekannt, an den kurzen Stirnseiten, sondern an einer seitlichen Längsseite der Verteilerleiste anzuschließen. Die seitliche Längsseite grenzt an eine vordere Längsseite an, welche auch als Vorderseite der Verteilerleiste bezeichnet werden kann. An dieser Längsseite sind auch die Anschlusseinrichtungen angeordnet. Die seitliche Längsseite ist im Allgemeinen etwa rechtwinklig zu der vorderen Längsseite. Hierbei kann die Verteilerleiste eine im Wesentlichen quaderförmige Form aufweisen.

Die erfindungsgemäße Anordnung des Zuleitungskabels an einer seitlichen Längsseite der Verteilerleiste hat den Vorteil, dass das Zuleitungskabel in einen Raum innerhalb des Geräteschrankes geführt werden kann, welcher üblicherweise ungenutzt ist und genügend Platz bietet, das Kabel in großem Bogen, das heißt mit großen Biegeradien, zu führen.

Ein weiterer Vorteil besteht darin, dass die seitliche Längsseite, insbesondere im Vergleich zu den Stirnseiten, genügend Platz für weitere Zuleitungskabel bietet: Hierdurch kann die Leistungsfähigkeit der Verteilerleiste, das heißt die maximal durch die Verteilerleiste an Verbraucher verteilbare Energie, gesteigert werden.

Die Verteilerleiste ist insbesondere dazu vorgesehen, in einem Eckbereich innerhalb des Schrankes in vertikaler Ausrichtung angeordnet zu werden. Hierzu ist an der Verteilerleiste erfindungsgemäß mindestens ein Befestigungsbereich vorgesehen, um die Verteilerleiste an dem Serverschrank, insbesondere dort vorhandenen Holmen oder Rahmenprofilen, zu befestigen. Der Befestigungsbereich kann beispielsweise als Klebefläche ausgebildet sein oder Befestigungsmittel, wie geeignete Rastmittel, Schrauben und/oder Löcher, aufweisen.

Die vertikale Anordnung der Verteilerleiste hat gegenüber der bekannten horizontalen Anordnung den Vorteil, dass die Verteilerleiste keinen ansonsten anderweitig nutzbaren Raum, insbesondere beispielsweise für weitere Geräte, einnimmt. Die Geräte sind in einem Geräteschrank oft so eingebaut beziehungsweise eingesetzt, dass ein Abstand zu den seitlichen Wänden besteht. Dieser seitliche Raum kann durch die erfindungsgemäße Verteilerleiste genutzt werden. Hierdurch können mehr Verbraucher beziehungsweise elektrische und elektronische Geräte im Rackbereich des Schrankes vorgesehen werden, da das Verteilersystem neben dem eigentlichen Rack vorgesehen ist. Somit kann die Anzahl der Geräte innerhalb eines Schrankes erhöht werden. Dabei ist insbesondere vorgesehen, das Zuleitungskabel entlang eines seitlichen Bereichs des Geräteschrankes zu führen. Als Radius für das Zuleitungskabel steht somit annähernd die gesamte Tiefe des Geräteschranks zur Verfügung. So können große Kabel mit großem Durchmesser beziehungsweise dicke Kabel für eine leistungsstarke Energieversorgung verwendet werden, da die für derartige Kabel notwendigen Biegeradien ermöglicht werden.

Mindestens eine Zuleitungskabel ist mittig an der zweiten Längsseite der Verteilerleiste angeschlossen. Unter dem Begriff "mittig" ist insbesondere der Bereich um die Mitte im Hinblick auf eine Längsachse der Verteilerleiste zu verstehen, welche sich parallel zu den Längsseiten erstreckt. Die mittige oder zentrale Anordnung des Zuleitungskabels hat den Vorteil, dass sowohl nach oben als auch nach unten Raum für das Verlegen des Zuleitungskabels vorhanden ist. Das Zuleitungskabel kann daher mit großem Biegeradius sowohl nach oben als auch nach unten aus dem Geräteschrank herausgeführt werden.

Grundsätzlich kann das Zuleitungskabel fest mit der Verteilerleiste verbunden sein. Es ist jedoch auch möglich, dass das Zuleitungskabel lösbar, insbesondere durch eine Steck- und/oder Drehverbindung mit der Verteilerleiste verbunden ist. Hierdurch wird eine hohe Flexibilität bezüglich der Wahl des Zuleitungskabels, insbesondere seiner Länge, erreicht.

Eine bevorzugte Ausgestaltung der Verteilerleiste besteht darin, dass mehrere, insbesondere drei, Zuleitungskabel vorgesehen sind. Dabei ist es möglich- dass die Kabel unterschiedlichen Stromanschlüssen oder Phasen zugeordnet sind, beispielsweise einem regulären Netzanschluss, einer unterbrechungsfreien Stromversorgung und/oder einem Notstromaggregat. Bei Anschluss an ein Drehstromnetz mit mehreren Phasen ist es auch möglich, jeweils ausgewählte Phasen über ausgewählte Zuleitungskabel zu leiten. Es bietet sich beispielsweise an, beim Verwenden von drei Zuleitungskabeln, jeweils eine andere Phase auf die drei Zuleitungen zu legen.

In einer weiteren bevorzugten Ausgestaltung ist vorgesehen, dass die elektrischen Anschlusseinrichtungen in mehrere, insbesondere funktional voneinander getrennte, Gruppen unterteilt sind. Beispielsweise können eine oder mehrere Gruppen jeweils einem Zuleitungskabel zugeordnet sein, so dass mehrere von einander unabhängige Strom- oder Versorgungskreise gebildet werden. Hierdurch kann bei dem Aufbau eines Serverschrankes mit der Verteilerleiste darauf geachtet werden, dass beispielsweise besonders wichtige Geräte an zusätzlich abgesicherten Gruppen oder Stromkreisen angeschlossen sind. Diese zusätzliche Absicherung kann beispielsweise durch eine zusätzliche USV oder dergleichen erfolgen.

Zur Erhöhung der Flexibilität der Verteilerleiste ist es bevorzugt, dass unterschiedliche elektrische Anschlusseinrichtungen vorgesehen sind. Die elektrischen Anschlusseinrichtungen können beispielsweise entsprechende Dosen oder Buchsen für Kaltgerätestecker, Warmgerätestecker und/oder Schukostecker sein. Ebenso ist es möglich, verschiedene Arten von Anschlüssen für unterschiedliche Kaltgerätestecker oder unterschiedliche andere Steckertypen vorzusehen.

In einer vorteilhaften Ausgestaltung ist vorgesehen, dass eine Datenanschlusseinrichtung zur Übertragung von Daten und/oder ein Messmodul an der Verteilerleiste angeordnet ist. Das Messmodul kann beispielsweise zum Messen des Stromverbrauchs einzelner Verbraucher, Verbrauchergruppen oder des Stroms der Zuleitungen eingerichtet sein. Weiterhin kann das Messmodul Informationen über angeschlossene Geräte, beispielsweise deren Anzahl liefern. Mittels der Datenanschlusseinrichtung können derartige oder andere Daten für ein Management der Verteilerleisten beispielsweise über ein Netzwerk abgefragt werden.

Die Benutzerfreundlichkeit der Verteilerleiste kann dadurch erhöht werden, dass eine Anzeigeeinrichtung vorgesehen ist. Die Anzeigeeinrichtung kann beispielsweise zum Anzeigen der Anzahl der angeschlossenen Geräte und/oder eines aktuellen Stromverbrauchs der Geräte eingerichtet sein. Somit wird eine visuelle Überwachung der Verteilerleiste vor Ort ermöglicht.

Eine vielseitig einsetzbare Verteilerleiste wird dadurch erreicht, dass Befestigungseinrichtungen vorhanden sind, welche ein Befestigen der Verteilerleiste in einem Geräte- oder Serverschrank in mindestens zwei Ausrichtungen ermöglicht, wobei die Verteilerleiste in einer zweiten Ausrichtung um 180° um ihre Querachse gegenüber einer ersten Ausrichtung gedreht ist. Beispielsweise können in einem unteren und einem oberen Bereich der Verteilerleiste jeweils Befestigungseinrichtungen vorgesehen sein, welche im Wesentlichen gleich ausgebildet sind, so dass die Verteilerleiste in einer auf dem Kopf stehenden Ausrichtung, in welcher eine Ober- und eine Unterseite vertauscht sind, an einem Geräteschrank befestigt werden kann. Ein und dieselbe Verteilerleiste kann daher für zwei unterschiedliche Anordnungspositionen verwendet werden.

Die Flexibilität der Verteilerleiste kann weiterhin dadurch erhöht werden, dass mindertens zwei Beschriftungen vorgesehen sind, welche zueinander, insbesondere um 180°, gedreht sind. Hierdurch wird erreicht, dass beim Drehen der Verteilerleiste, deren Beschriftungen unabhängig von der Ausrichtung gut lesbar sind.

Der erfindungsgemäße Serverschrank ist in einer vorteilhaften Ausgestaltung dadurch weitergebildet, dass die Verteilerleiste in einem ersten Eckbereich im Bereich einer Seitenwand des Schrankes vertikal angeordnet ist. Vorteilhaft ist es, wenn das Zuleitungskabel im Wesentlichen horizontal aus der Verteilerleiste herausgeführt ist und bogenförmig entlang einer Seitenwand des Schrankes nach oben oder unten geführt ist. Das Zuleitungskabel wird somit zwischen in dem Geräteschrank angeordneten Geräten und einer inneren Oberfläche einer Seitenwand geführt. Dieser Bereich ist im Allgemeinen ungenutzt und bietet genügend Platz für ein mit einem großen Biegeradius verlegtes Zuleitungskabel.

Zum flexiblen Einsetzen der Verteilerleiste in unterschiedlichen Eckbereichen des Geräteschrankes ist in einer vorteilhaften Ausgestaltung vorgesehen, dass die Verteilerleiste in einer ersten Ausrichtung in einem ersten Eckbereich des Geräteschrankes und in einer zweiten Ausrichtung in einem dem ersten Eckbereich gegenüberliegenden zweiten Eckbereich des Geräteschrankes befestigbar ist, wobei die Verteilerleiste in der zweiten Ausrichtung um 180° um ihre Querachse gegenüber der ersten Ausrichtung gedreht ist. Unter einer Querachse ist insbesondere eine Achse zu verstehen, welche sich senkrecht zu einer Längsachse der Verteilerleiste und parallel zur Vorderseite sowie zu den Stirnseiten erstreckt. Anders ausgedrückt kann die Querachse als Verlängerung eines mittig vorgesehenen Zuleitungskabels angesehen werden. Durch das seitlich angeordnete Zuleitungskabel kann die Verteilerleiste zum Anordnen an einem gegenüberliegenden Eckbereich nicht lediglich um ihre Längsachse gedreht werden. Daher ist vorgesehen, die Verteilerleiste so zu drehen, dass Unter- und Oberseite vertauscht werden und die Verteilerleiste auf dem Kopf stehend an der zweiten Ecke des Geräteschrankes angebracht wird. In diesem Zusammenhang sind insbesondere auch die doppelten, um 180° gedrehten Beschriftungen der Verteilerleiste von Vorteil.

Um möglichst kurze Wege zwischen einem anzuschließenden Gerät und einer Anschlusseinrichtung der Verteilerleiste bereitzustellen, ist es bevorzugt, dass die Verteilerleiste eine Länge aufweist, welche im Wesentlichen der Höhe des Innenraums des Schrankes entspricht. Hierdurch ist es möglich, bei den in dem Schrank vorgesehenen Verbrauchern lediglich äußerst kurze Stromkabel vorzusehen, da sich eine Anschlusseinrichtung bereits auf derselben Höhe wie ein im Rack eingebauter Verbraucher befindet.

Mit einer derartigen langen Verteilerleiste kann zudem eine große Anzahl an Anschlusseinrichtungen zur Verfügung gestellt werden. Aufgrund der kurzen Stromkabel kann darüber hinaus die Übersichtlichkeit der Anschlüsse deutlich verbessert werden. Bevorzugt ist es in diesem Zusammenhang auch, die Anschlusseinrichtungen in Gruppen zu unterteilen, welche beispielsweise jeweils einem bestimmten Abschnitt des Schrankes zugeordnet sein können.

Bevorzugt ist es auch, dass zwei Verteilerleisten in oder an einem Serverschrank angeordnet sind, wobei eine erste Verteilerleiste in einem ersten Eckbereich des Schrankes und eine zweite Verteilerleiste in einem zweiten Eckbereich des Schrankes angeordnet ist. Hierdurch kann die Anzahl der verfügbaren Anschlusseinrichtungen noch weiter erhöht werden.

Die grundlegenden Gedanken der Erfindung können demnach darin gesehen werden, eine Verteiler- oder Dosenleiste mit einer seitlichen Kabelzuführung vorzusehen. Ferner soll die Verteilerliste um ihre Querachse um 180° drehbar sein, so dass sie an unterschiedlichen Stellen eines Serverschrankes eingebaut werden kann.

Die Erfindung wird nachfolgend anhand von Zeichnungen weiter beschrieben. In den Zeichnungen zeigt
- Fig. 1: eine perspektivische Ansicht einer erfindungsgemäßen Verteilerleiste;
- Fig. 2: einen vergrößerten Bereich der Verteilerleiste aus Fig. 1;
- Fig. 3: eine perspektivische Ansicht eines Geräteschranks mit zwei Verteilerleisten und nach unten geführten Zuleitungskabeln; und
- Fig. 4: eine perspektivische Ansicht eines Geräteschranks mit zwei Verteilerleisten und nach oben geführten Zuleitungskabeln.

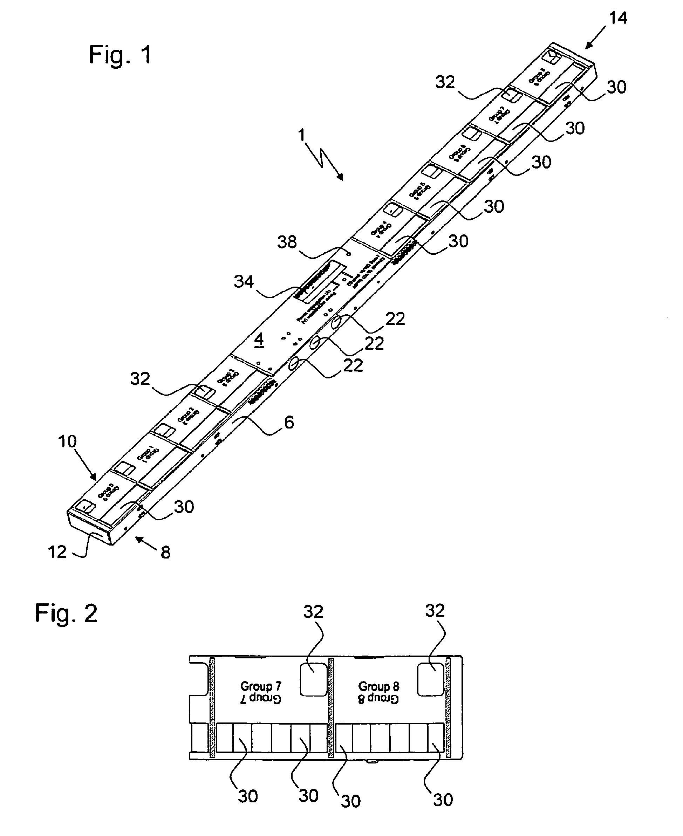

Fig. 1 zeigt eine perspektivische Ansicht einer Verteilerleiste 1. Die Verteilerleiste 1 hat eine im Wesentlichen quaderförmige äußere Kontur mit vier Längsseiten 4, 6, 8, 10 und zwei Stirnseiten 12, 14. Die Stirnseiten 12, 14 haben eine rechteckige Gestalt, so dass die Verteilerleiste 1 insgesamt eine langgestreckte, flache Form aufweist. An einer ersten Längsseite 4 der Verteilerleiste 1, welche auch als Vorderseite bezeichnet werden kann, ist eine Vielzahl von Anschlusseinrichtungen 30, 32 zum Anschließen von elektrischen und/oder elektronischen Komponenten angeordnet. Die Anschlusseinrichtungen 30, 32, welche in der Fig. 1 nur schematisch angedeutet sind, können beispielsweise Kaltgeräteanschlussdosen sein, an welche Anschlusskabel mit entsprechenden Steckern angeschlossen werden können. Die Anschlusseinrichtungen 30, 32 stellen Stromausgänge der Verteilerleiste 1 dar.

Um unterschiedliche Geräte an die Verteilerleiste 1 anzuschließen, weist die Verteilerleiste 1 unterschiedliche Anschlusseinrichtungen 30, 32 auf. Die Anschlusseinrichtungen 30, 32 sind bei der dargesteiiten Verteilerieiste 1 in neun Gruppen unterteilt. Jede Gruppe weist hier sieben Anschlusseinrichtungen 30 eines ersten Typs und eine Anschlusseinrichtung 32 eines zweiten Typs auf.

In einem mittleren Bereich der Verteilerleiste 1 ist auf der ersten Längsseite 4 eine Anzeigeeinrichtung 34 für die Anzeige des Stromverbrauchs der Anschlusseinrichtungen 30, 32 beziehungsweise der daran angeschlossenen Verbraucher vorgesehen. Weiterhin befinden sich in dem mittleren Bereich der Verteilerleiste 1 ein Datenanschluss und ein Reset-Schalter 38. Die Anzeigeeinrichtung 34 kann als LCD-Anzeige oder Mehrsegment-Anzeige ausgebildet sein.

An einer der Vorderseite benachbarten zweiten Längsseite 6 sind drei Aussparungen 22 für Zuleitungskabel 20 vorgesehen. Die Aussparungen 22 befinden sich etwa in einem mittigen Bereich der Verteilerleiste 1.

Fig. 2 zeigt in vergrößerter Darstellung einen Bereich der Anschlussleiste 1 mit zwei Gruppen von Anschlusseinrichtungen 30, 32. Jede Gruppe weist sieben gleiche Anschlusseinrichtungen 30 auf, welche in einer Reihe längs entlang der Verteilerleiste 1 angeordnet sind. Eine weitere Anschlusseinrichtung 32 ist beabstandet von den sieben gleichen Anschlusseinrichtungen 30 angeordnet. An den Enden der Verteilerleiste 1 können sich jeweils Befestigungseinrichtungen zum Befestigen der Verteilerleiste 1 an dem Geräteschrank 50 befinden, die als kragenförmige Verlängerungen einer Seite ausgeführt sein können.

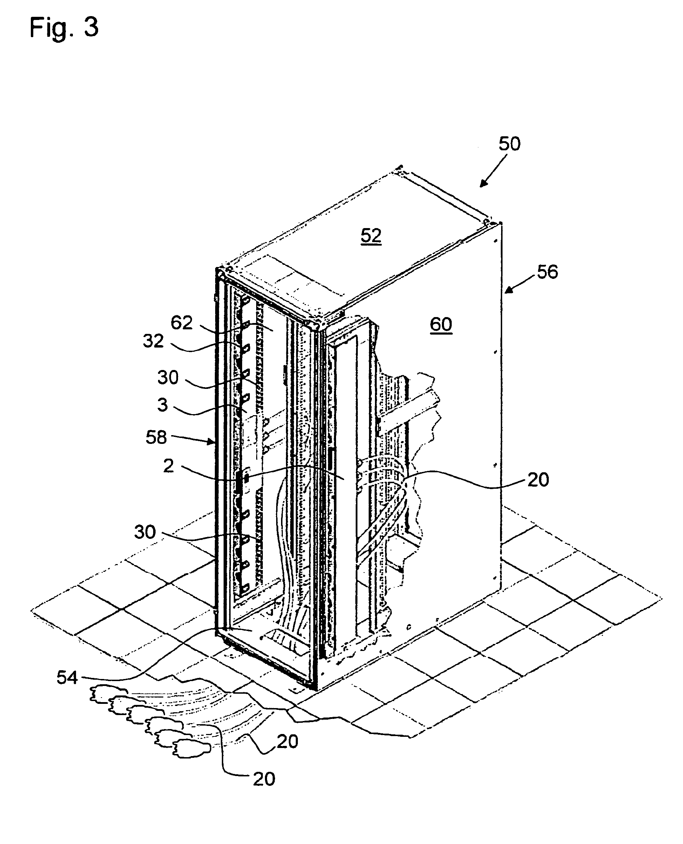

Fig. 3 zeigt eine perspektivische Ansicht eines Geräteschranks 50 mit zwei eingebauten Verteilerleisten 2, 3. Der Geräteschrank 50 weist eine Oberseite 52, eine Unterseite 54, eine Vorderseite 56, eine Rückseite 58, eine erste Seitenwand 60 und eine zweite Seitenwand 62 auf. Eine erste Verteiterleiste 2 ist in einem rückwärtigen Bereich des Geräteschrankes 50 in einem Eckbereich zwischen der Rückseite 58 und der ersten Seitenwand 60 angeordnet. Eine Längsachse der ersten Verteilerleiste 2 erstreckt sich im Wesentlichen parallel zu allen Längsseiten 4, 6, 8, 10 und vertikal zwischen Unterseite 54 und Oberseite 52 des Geräteschranks 50. Eine Querachse erstreckt sich parallel zur ersten Längsseite 4 und zu den Stirnseiten 12, 14 der Verteilerleiste 2. Die Vorderseite der Verteilerleiste 2 ist parallel zu den Seitenwänden 60, 62 ausgerichtet. Die zweite Längsseite 6 der Verteilerleiste 2, aus welcher die Zuleitungskabel 20 herausgeführt sind, erstreckt sich parallel zur Vorder- beziehungsweise Rückseite 56, 58 des Geräteschrankes 50. Eine zweite Verteilerleiste 3 ist in einem zweiten Eckbereich des Geräteschrankes 50 angebracht. Der zweite Eckbereich befindet sich zwischen der Rückseite 58 und der zweiten Seitenwand 62 des Geräteschrankes 50. In dieser Figurenbeschreibung wird von einer idealen Ausrichtung und Befestigung der Verteilerleisten ausgegangen. In real eingebauten Verteilerleisten liegt demnach jeweils nur eine im Wesentlichen parallele, senkrechte und vertikale Ausrichtung vor.

Die Zuleitungskabel 20 sind aus den Verteilerleisten 2, 3 im Wesentlichen horizontal herausgeführt und verlaufen im Weiteren bogenförmig parallel zur ersten beziehungsweise zweiten Seitenwand 60, 62 des Geräteschranks 50 nach unten. Durch eine Öffnung in der Unterseite 54 des Geräteschranks 50 sind die Kabel herausgeführt. Für die Verlegung der Zuleitungskabel 20 steht im Wesentlichen der seitliche Raum zwischen in dem Geräteschrank 50 angeordneten Geräten und Seitenwand 60, 62 zur Verfügung. Aufgrund dieses großen Raumangebots für die Zuleitungskabel 20 können die Zuleitungskabel 20 große Durchmesser aufweisen und mit entsprechend großen Biegeradien verlegt werden.

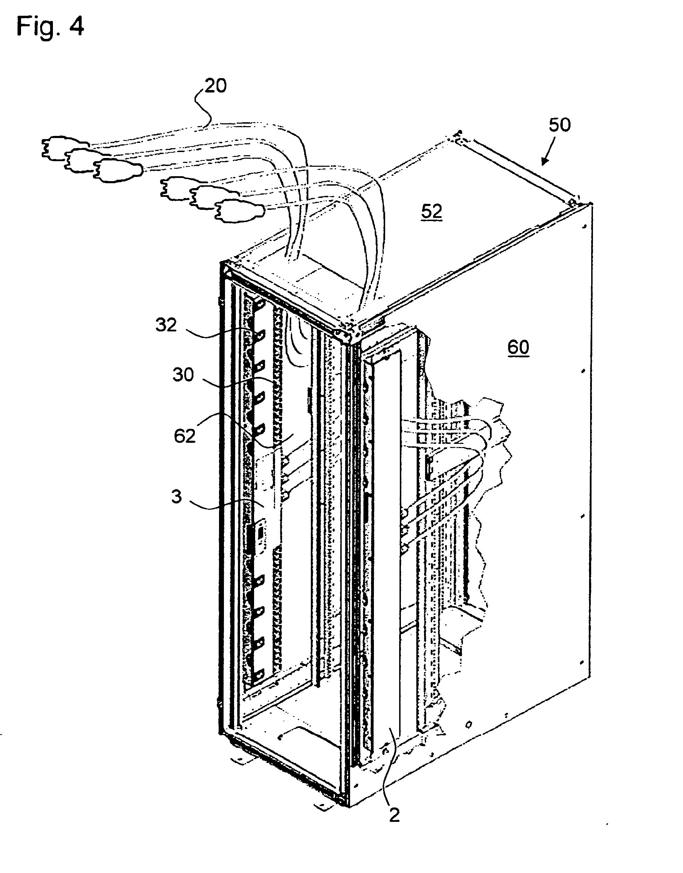

Fig. 4 zeigt eine alternative Führung der Zuleitungskabel 20. Die Zuleitungskabel 20 werden entlang der ersten beziehungsweise zweiten Seitenwand 60, 62 nach oben und durch eine Öffnung in der Oberseite 52 aus dem Geräteschrank 50 herausgeführt. Der Austritt der Zuleitungskabel 20 aus dem Geräteschrank 50 erfolgt in einem hinteren, seitlichen Bereich der Oberseite 52.

Insgesamt wird mit dem erfindungsgemäßen Serverschrank eine leistungsstarke Stromversorgung von Verbrauchern in einen Geräteschrank erreicht. Insbesondere wird die Verwendung eines Zuleitungskabels mit großem Durchmesser und entsprechend großem Biegeradius ermöglicht.

## Patentansprüche

1. Serverschrank zur Aufnahme von elektrischen und/oder elektronischen Geräten, mit einer Verteilerleiste zur Verteilung von elektrischer Energie an die in dem Serverschrank angeordneten Geräte,
- wobei die Verteilerleiste aufweist:
- mehrere elektrische Anschlusseinrichtungen (30, 32), an welche elektrische Verbraucher anschließbar sind,
- mindestens ein Zuleitungskabel (20) zum Verbinden der Verteilerleiste (1, 2, 3) mit einer Energiequelle
- mindestens einen Befestigungsbereich zum Befestigen der Verteilerleiste (1, 2, 3) an dem Serverschrank (50),
- wobei die elektrischen Anschlusseinrichtungen (30, 32) an einer ersten Längsseite (4) der Verteilerleiste (1, 2, 3) angeordnet sind,
- wobei die Verteilerleiste (1, 2, 3) mittels des Befestigungsbereichs in einer vertikalen Ausrichtung im Bereich einer Seitenwand (60; 62) an dem Serverschrank (50) befestigbar ist und
- wobei das mindestens eine Zuleitungskabel (20) an einer der ersten Längsseite (4) benachbarten zweiten Längsseite (6) der Verteilerleiste (1, 2, 3) angeordnet ist,
**dadurch gekennzeichnet,**
**dass** das mindestens eine Zuleitungskabel (20) der Verteilerleiste mittig an der zweiten Längsseite (6) der Verteilerleiste (1, 2, 3) angeschlossen ist.

2. Serverschrank nach Anspruch 1 ,
**dadurch gekennzeichnet,**
**dass** Befestigungseinrichtungen vorhanden sind, welche ein Befestigen der Verteilerleiste (1, 2, 3) in dem Geräte- oder Serverschrank (50) in mindestens zwei Ausrichtungen ermöglicht, wobei die Verteilerleiste (1, 2, 3) in einer zweiten Ausrichtung um 180° um ihre Querachse gegenüber einer ersten Ausrichtung gedreht ist.

3. Serverschrank nach Anspruch 1 oder 2 ,
**dadurch gekennzeichnet,**
**dass** unterschiedliche elektrische Anschlusseinrichtungen (30, 32) vorgesehen sind.

4. Serverschrank nach einem der Ansprüche 1 bis 3,
**dadurch gekennzeichnet,**
**dass** mehrere, insbesondere drei, Zuleitungskabel (20) vorgesehen sind.

5. Serverschrank nach einem der Ansprüche 1 bis 4,
**dadurch gekennzeichnet,**
**dass** die elektrischen Anschlusseinrichtungen (30, 32) in mehrere, insbesondere funktional voneinander getrennte, Gruppen unterteilt sind.

6. Serverschrank nach einem der Ansprüche 1 bis 5,
**dadurch gekennzeichnet,**
**dass** mindestens zwei Beschriftungen an der Verteilerleiste (1, 2, 3) vorgesehen sind, welche zueinander, insbesondere um 180°, gedreht sind.

7. Serverschrank nach einem der Ansprüche 1 bis 6,
**dadurch gekennzeichnet,**
**dass** eine Datenanschlusseinrichtung zur Übertragung von Daten und/oder ein Messmodul an der Verteilerleiste (1, 2, 3) angeordnet ist.

8. Serverschrank nach einem der Ansprüche 1 bis 7,
**dadurch gekennzeichnet,**
**dass** eine Anzeigeeinrichtung (34), insbesondere zum Anzeigen eines aktuellen Stromverbrauchs, vorgesehen ist.

9. Serverschrank nach einem der Ansprüche 1 bis 8,
**dadurch gekennzeichnet,**
**dass** die Verteilerleiste (1, 2, 3) in einem ersten Eckbereich im Bereich einer Seitenwand (60, 62) innerhalb des Schrankes (50) im Wesentlichen vertikal angeordnet ist.

10. Serverschrank nach einem der Ansprüche 1 bis 9,
**dadurch gekennzeichnet,**
**dass** das mindestens eine Zuleitungskabel (20) entlang einer Seitenwand (60, 62) des Schrankes (50) geführt ist.

11. Serverschrank nach einem der Ansprüche 1 bis 10,
**dadurch gekennzeichnet,**
**dass** die Verteilerleiste (1, 2, 3) in einer ersten Ausrichtung in einem ersten Eckbereich des Geräteschrankes und in einer.zweiten Ausrichtung in einem dem ersten Eckbereich gegenüberliegenden zweiten Eckbereich des Geräteschrankes befestigbar ist, wobei die Verteilerleiste (1, 2, 3) in der zweiten Ausrichtung um 180° um ihre Querachse gegenüber der ersten Ausrichtung gedreht ist.

12. Serverschrank nach einem der Ansprüche 1 bis 11,
**dadurch gekennzeichnet,**
**dass** die Verteilerleiste (1, 2, 3) eine Länge aufweist, welche im Wesentlichen der Höhe des Innenraums des Schrankes (50) entspricht.

## Claims

1. Server cabinet for receiving electrical and / or electronic devices, comprising a distribution strip for distributing electrical energy to the devices arranged in the server cabinet,
- wherein the distribution strip comprises:
- a plurality of electrical connection devices (30, 32) to which electrical consumers can be connected,
- at least one feed cable (20) for connecting the distribution strip (1, 2, 3) to an energy source,
- at least one fixing region for fixing the distribution strip (1, 2, 3) to the server cabinet (50),
- wherein the electrical connection devices (30, 32) are arranged on a first longitudinal side (4) of the distribution strip (1, 2, 3),
- wherein the distribution strip (1, 2, 3) can be fixed by means of the fixing region in a vertical orientation in the region of a side wall (60; 62) to the server cabinet (50) and
- wherein the at least one feed cable (20) is arranged on a second longitudinal side (6) of the distribution strip (1, 2, 3) adjacent to the first longitudinal side (4),
**characterised in that**
the at least one feed cable (20) of the distribution strip is connected centrally to the second longitudinal side (6) of the distribution strip (1, 2, 3).

2. Server cabinet according to claim 1,
**characterised in that**
fixing devices are present which allow fixing of the distribution strip (1, 2, 3) in the equipment or server cabinet (50) in at least two orientations, whereby the distribution strip (1, 2, 3) is rotated in a second orientation by 180° about its transverse axis in relation to a first orientation.

3. Server cabinet according to claim 1 or 2,
**characterised in that**
different electrical connection devices (30, 32) are provided.

4. Server cabinet according to one of the claims 1 to 3,
**characterised in that**
a plurality of, in particular three, feed cables (20) are provided.

5. Server cabinet according to one of the claims 1 to 4,
**characterised in that**
the electrical connection devices (30, 32) are divided into a plurality of groups, in particular which are functionally separated from each other.

6. Server cabinet according to one of the claims 1 to 5,
**characterised in that**
at least two inscriptions are provided on the distribution strip (1, 2, 3) which are rotated, particularly by 180°, relative to each other.

7. Server cabinet according to one of the claims 1 to 6,
**characterised in that**
a data connection device for transmission of data and/or a measurement module is arranged on the distribution strip (1, 2, 3).

8. Server cabinet according to one of the claims 1 to 7,
**characterised in that**
a display device (34), in particular for displaying current power consumption, is provided.

9. Server cabinet according to one of the claims 1 to 8,
**characterised in that**
the distribution strip (1, 2, 3) is arranged essentially vertically in a first corner region in the area of a side wall (60, 62) within the cabinet (50).

10. Server cabinet according to one of the claims 1 to 9,
**characterised in that**
the at least one feed cable (20) is guided along a side wall (60, 62) of the cabinet (50).

11. Server cabinet according to one of the claims 1 to 10,
**characterised in that**
the distribution strip (1, 2, 3) can be fixed in a first orientation in a first corner region of the equipment cabinet and in a second orientation in a second corner region of the equipment cabinet lying opposite the first corner region, whereby the distribution strip (1, 2, 3) is rotated in the second orientation by 180° about its transverse axis in relation to the first orientation.

12. Server cabinet according to one of the claims 1 to 11,
**characterised in that**
the distribution strip (1, 2, 3) has a length which corresponds essentially to the height of the inner space of the cabinet (50).

## Revendications

1. Armoire pour serveur, destinée à recevoir des appareils électriques et/ou électroniques, avec une barrette de distribution pour distribuer de l'énergie électrique aux appareils placés dans l'armoire de serveur,
- dans laquelle la barrette de distribution comprend :
- plusieurs dispositifs de raccordement électrique (30, 32) auxquels des consommateurs électriques peuvent être raccordés,
- au moins un câble d'alimentation (20) pour relier la barrette de distribution (1, 2, 3) à une source d'énergie,
- au moins une zone de fixation pour fixer la barrette de fixation (1, 2, 3) à l'armoire (50) pour serveur,
- dans laquelle les dispositifs de raccordement électrique (30, 32) sont placés sur un premier côté longitudinal (4) de la barrette de distribution (1, 2, 3),
- dans lequel la barrette de distribution (1, 2, 3) peut être fixée au moyen de la zone de fixation dans une orientation verticale au niveau d'une paroi latérale (60, 62) sur l'armoire (50) pour serveur, et
- dans laquelle ledit au moins un câble d'alimentation (20) est placé sur un deuxième côté longitudinal (6) de la barrette de distribution (1, 2, 3) voisin du premier côté longitudinal (4),
***caractérisé en ce que***
ledit au moins un câble d'alimentation (20) de la barrette de distribution est raccordé au centre sur le deuxième côté longitudinal (6) de la barrette de distribution (1, 2, 3).

2. Armoire pour serveur selon la revendication 1, ***caractérisée en ce que*** des dispositifs de fixation sont présents, qui permettent une fixation de la barrette de distribution (1, 2, 3) dans l'armoire à appareils ou armoire (50) pour serveur dans au moins deux orientations, la barrette de distribution (1, 2, 3) étant, dans une deuxième orientation, tournée de 180° autour de son axe transversal par rapport à une première orientation.

3. Armoire pour serveur selon la revendication 1 ou 2, ***caractérisée en ce que*** différents dispositifs de raccordement électrique (30, 32) sont prévus.

4. Armoire pour serveur selon l'une quelconque des revendications 1 à 3, ***caractérisée en ce que*** plusieurs câbles d'alimentation (20), en particulier trois, sont prévus.

5. Armoire pour serveur selon l'une quelconque des revendications 1 à 4, ***caractérisée en ce que*** les dispositifs de raccordement électrique (30, 32) sont subdivisés en plusieurs groupes, en particulier fonctionnellement séparés.

6. Armoire pour serveur selon l'une quelconque des revendications 1 à 5, *caractérisée en ce qu*'au moins deux inscriptions sont prévues sur la barrette de distribution (1, 2, 3), lesquelles sont tournées l'une par rapport à l'autre, en particulier de 180°.

7. Armoire pour serveur selon l'une quelconque des revendications 1 à 6, *caractérisée en ce qu*'un dispositif de raccordement de données pour transmettre des données et/ou un module de mesure est placé sur la barrette de distribution (1, 2, 3).

8. Armoire pour serveur selon l'une quelconque des revendications 1 à 7, *caractérisée en ce qu*'un dispositif d'affichage (34) est prévu, en particulier pour afficher une consommation courante d'électricité.

9. Armoire pour serveur selon l'une quelconque des revendications 1 à 8, ***caractérisée en ce que*** la barrette de distribution (1, 2, 3) est placé sensiblement verticalement dans une première zone de coin au niveau d'une paroi latérale (60, 62) à l'intérieur de l'armoire (50).

10. Armoire pour serveur selon l'une quelconque des revendications 1 à 9, ***caractérisée en ce que*** ledit au moins un câble d'alimentation (20) passe le long d'une paroi latérale (60, 62) de l'armoire (50).

11. Armoire pour serveur selon l'une quelconque des revendications 1 à 10, ***caractérisée en ce que*** la barrette de distribution (1, 2, 3) peut être fixée dans une première orientation dans une première zone de coin et dans une deuxième orientation dans une deuxième zone de coin opposée à la première zone de coin de l'armoire à appareil, la barrette de distribution (1, 2, 3) étant, dans la deuxième orientation, tournée de 180° autour de son axe transversal par rapport à la première orientation.

12. Armoire pour serveur selon l'une quelconque des revendications 1 à 11, ***caractérisée en ce que*** la barrette de distribution (1, 2, 3) présente une longueur qui correspond pour l'essentiel à la hauteur de l'espace intérieur de l'armoire (50).
